# FASCICULE DE BREVET EUROPEEN

(11) **EP 3 346 609 B1**
(45) Date de publication et mention de la délivrance du brevet: **30.11.2022**
(21) Numéro de dépôt: 18150884.7
(22) Date de dépôt: 09.01.2018
(51) Int. Cl.: H03K 3/3562, H03M 9/00, H04L 7/033

(54) **DISPOSITIF ÉCHANTILLONNEUR-BLOQUEUR DE SIGNAL ÉLECTRIQUE**
ABTAST-/BLOCKIERVORRICHTUNG EINES ELEKTRISCHEN SIGNALS
ELECTRICAL SIGNAL SAMPLE AND HOLD DEVICE

(30) Priorité: 10.01.2017 FR 1700025
(43) Date de publication de la demande: 11.07.2018
(73) Titulaire: Thales, 92400 Courbevoie (FR)
(72) Inventeur: MEYER, Arnaud, 78851 Elancourt Cedex (FR); LOUIS, Bruno, 78851 Elancourt Cedex (FR); CORBIERE, Rémi, 78851 Elancourt Cedex (FR); PETIT, Vincent, 78851 Elancourt Cedex (FR); DESGREYS, Patricia, 75013 Paris (FR); PETIT, Hervé, 75013 Paris (FR)
(74) Mandataire: Lavoix

(56) Documents cités:
- EP-A1- 0 843 418
- EP-B1- 0 843 418
- FR-A1- 3 004 875
- GB-A- 2 069 267
- US-A1- 2007 236 380

## Description

La présente invention concerne un dispositif échantillonneur-bloqueur de signal électrique.

L'invention se situe dans le domaine de la conversion analogique-numérique des signaux.

Il est connu d'utiliser des dispositifs ou circuits échantillonneurs-bloqueurs en entrée d'un convertisseur analogique-numérique, pour réaliser l'acquisition d'une valeur de tension du signal analogique fourni en entrée, et le maintien de la valeur de tension stable pendant la durée de la conversion, avant la conversion des valeurs de tension en valeurs binaires.

On connaît notamment la réalisation d'un circuit échantillonneur-bloqueur à double commutation (ou « double switching » en anglais), comprenant deux modules suiveurs-bloqueurs branchés en série, un premier module suiveur-bloqueur maître étant branché en série en sortie d'un amplificateur d'entrée à deux commutateurs, et un deuxième module suiveur-bloqueur esclave étant branché en série en sortie du premier module suiveur-bloqueur. Le deuxième module suiveur-bloqueur est branché en entrée d'un amplificateur de sortie à deux commutateurs. Le deuxième module suiveur-bloqueur est commandé par un deuxième signal d'horloge en opposition de phase par rapport au premier signal d'horloge de manière à suivre et maintenir un échantillon bloqué. Chaque module suiveur-bloqueur est apte à fonctionner alternativement selon un mode passant, puis selon un mode bloqué, en fonction du signal d'horloge de commande.

Une telle structure classique permet d'obtenir en sortie un signal de sortie qui est échantillonné deux fois plus rapidement que le signal issu d'un unique module suiveur-bloqueur.

Cependant, un tel circuit à deux modules suiveurs-bloqueurs branchés en série présente plusieurs inconvénients.

Un premier inconvénient est que le deuxième module suiveur-bloqueur bloque le signal issu du premier module suiveur-bloqueur au moment de la transition entre le mode passant et le mode bloqué, ce qui engendre des erreurs de commutation supplémentaires, et par conséquent la linéarité de l'échantillonneur-bloqueur est dégradée. On entend par linéarité de l'échantillonneur-bloqueur (E/B) le taux de distorsion harmonique totale qui est défini comme le rapport de la valeur efficace globale des harmoniques (c'est-à-dire leur somme quadratique) à la valeur efficace de la composante.

Un deuxième inconvénient d'un tel circuit échantillonneur-bloqueur est que le moment d'échantillonnage entre les deux modules suiveurs-bloqueurs est lié et non contrôlable.

Enfin, un troisième inconvénient est que le facteur de bruit est augmenté, puisque les bruits introduits respectivement par les suiveurs-bloqueurs sont cumulés, du fait du fonctionnement en mode maître-esclave.

Le document EP 0 843 418 A1 décrit un convertisseur série/parallèle d'un signal haute fréquence faible amplitude, qui comporte plusieurs échantillonneurs-bloqueurs.

Le document FR 3 004 875 A1 décrit un convertisseur analogique-numérique différentiel avec commutation périodique des voies.

Afin de pallier certains des inconvénients de l'état de la technique pré-cités, l'invention propose un dispositif échantillonneur-bloqueur de signal électrique selon la revendication 1.

Avantageusement, le dispositif échantillonneur-bloqueur comporte deux modules suiveurs-bloqueurs branchés en parallèle, dont le moment d'échantillonnage est contrôlable indépendamment. La linéarité est augmentée et le facteur de bruit est réduit.

Le dispositif échantillonneur-bloqueur selon l'invention peut également présenter une ou plusieurs des caractéristiques des revendications 2 à 9, selon toute combinaison techniquement acceptable.

D'autres caractéristiques et avantages de l'invention ressortiront de la description qui en est donnée ci-dessous, à titre indicatif et nullement limitatif, en référence aux figures annexées, parmi lesquelles :
- la figure 1 représente un selon dispositif échantillonneur-bloqueur un mode de réalisation de l'invention;
- la figure 2 représente un exemple de chronogramme de signaux d'horloge, sans et avec correction par un courant de décalage.

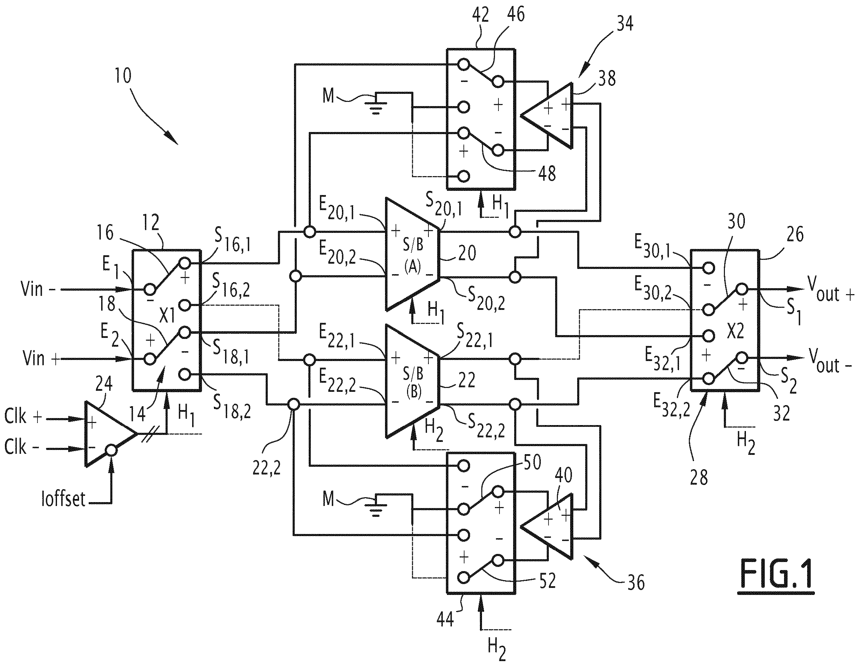

La figure 1 illustre un dispositif échantillonneur-bloqueur 10 selon un mode de réalisation de l'invention.

Le dispositif échantillonneur-bloqueur 10 est un échantillonneur-bloqueur à deux voies, fonctionnant en entrelacement temporel.

Ce dispositif échantillonneur-bloquer 10 comporte un module d'entrée 12, qui réalise une fonction d'amplification et une fonction de commutation.

Le module d'entrée 12 a deux entrées de signal, une première entrée E₁ et une deuxième entrée E₂.

Le module d'entrée 12 comprend un premier bloc de commutation 14 à deux commutateurs 16, 18, dits commutateurs d'entrée, la première entrée E₁ étant connectée à l'entrée du premier commutateur d'entrée 16, et la deuxième entrée E₂ étant connectée à l'entrée du deuxième commutateur d'entrée 18.

Les entrées sont alimentées, lorsque le dispositif échantillonneur-bloqueur 10 est mis sous tension, par une source de courant alternatif non représentée. Dans l'exemple, une tension Vᵢₙ₋ est fournie sur la première entrée E₁ et une tension Vᵢₙ₊ sur la deuxième entrée E₂.

Chacun des commutateurs d'entrée 16, 18 a une entrée et deux sorties, notées respectivement S_{16,1} et S_{16,2} pour le premier commutateur d'entrée 16, et S_{18,1} et S_{18,2} pour le deuxième commutateur d'entrée 18.

Le dispositif échantillonneur-bloqueur 10 comporte deux modules suiveurs-bloqueurs 20, 22, qui sont branchés en parallèle, un premier module suiveur-bloqueur 20 correspondant à une première voie de traitement de signal, notée voie A, et un deuxième module suiveur-bloqueur 22, correspondant à une deuxième voie de traitement de signal, notée voie B.

Chaque module suiveur-bloqueur 20, 22 est un dispositif à deux entrées et deux sorties.

On appelle module suiveur-bloqueur un circuit cadencé à une fréquence d'horloge qui suit le signal admis à son entrée pendant la première demi-période de l'horloge et maintient (bloque) le signal capturé pendant la deuxième demi-période de l'horloge. De tels dispositifs sont connus et sont réalisés ici selon tout mode de réalisation connu de l'homme du métier.

La première sortie S_{16,1} du premier commutateur d'entrée 16 est branchée à la première entrée E_{20,1} du premier module suiveur-bloqueur 20, et la deuxième sortie S_{16,2} du premier commutateur d'entrée 16 est branchée à la première entrée E_{22,1} du deuxième module suiveur-bloqueur 22.

La première sortie S_{18,1} du deuxième commutateur d'entrée 18 est branchée à la deuxième entrée E_{20,2} du premier module suiveur-bloqueur 20, et la deuxième sortie S_{18,2} du deuxième commutateur d'entrée 18 est branchée à la deuxième entrée E_{22,2} du deuxième module suiveur-bloqueur 22.

Le premier bloc de commutation 14 est commandé par un signal d'horloge H₁, émis par un générateur d'horloge 24.

Le signal d'horloge H₁ a une fréquence d'horloge donnée Fₛ.

Les deux commutateurs d'entrée 16, 18 du premier bloc de commutation 14 sont ainsi commandés pour basculer périodiquement à la période 1/Fₛ, fonction de la fréquence du signal de commande qui est le signal d'horloge H₁, entre une première position de fonctionnement et une deuxième position de fonctionnement.

Dans la première position de fonctionnement, qui correspond à un mode de fonctionnement dit mode passant, le premier commutateur d'entrée 16 connecte la première entrée E₁, après amplification, à la première entrée E_{20,1} du premier module suiveur-bloqueur 20, et le deuxième commutateur d'entrée 18 connecte la deuxième entrée E₂, après amplification, à la deuxième entrée E_{20,2} du premier module suiveur-bloqueur 20.

Dans la deuxième position de fonctionnement, qui correspond à un mode de fonctionnement dit mode bloqué, le premier commutateur d'entrée 16 connecte la première entrée E₁, après amplification, à la première entrée E_{22,1} du deuxième module suiveur-bloqueur 22, et le deuxième commutateur d'entrée 18 connecte la deuxième entrée E₂, après amplification, à la deuxième entrée E_{22,2} du deuxième module suiveur-bloqueur 22.

En d'autres termes, le premier bloc de commutation 14 dévie le signal d'entrée vers le premier module suiveur-bloqueur 20 (voie A) en mode passant et le signal d'entrée vers le deuxième module suiveur-bloqueur 22 (voie B) en mode bloqué.

Ainsi, le premier bloc de commutation 14 réalise un démultiplexage du signal d'entrée, de manière alternée, entre la voie A, correspondant au premier module suiveur-bloqueur 20, et la voie B, correspondant au deuxième module suiveur-bloqueur 22.

Selon un mode de réalisation alternatif, le module d'entrée 12 réalise seulement la fonction de commutation décrite ci-dessus, sans amplification.

Avantageusement, la commutation réalisée par ce branchement du premier bloc de commutation 14 permet de mutualiser le courant d'entrée, ce qui permet d'utiliser, dans le module d'entrée 12, un amplificateur dimensionné pour une charge d'un seul module suiveur-bloqueur, et non de deux modules suiveurs-bloqueurs distincts. Par conséquent, une économie d'énergie est ainsi réalisée.

De plus, avantageusement, le premier bloc de commutation 14 permet d'augmenter l'isolation des entrées E₁, E₂ par rapport au module suiveur-bloqueur qui maintient l'échantillon.

Les modules suiveurs-bloqueurs 20, 22 traitent les signaux d'entrée indépendamment.

Chacun des modules suiveurs-bloqueurs 20, 22 est commandé par un signal d'horloge de commande respectif H₁, H₂, le signal d'horloge H₂ étant issu du même générateur d'horloge 24, mais inversé par rapport au signal d'horloge H₁.

En d'autres termes, le signal d'horloge H₂ est en opposition de phase par rapport au signal d'horloge H₁.

Le signal d'horloge H₂ a la même fréquence d'horloge Fₛ que le signal d'horloge H₁.

Dans un mode de réalisation, le signal d'horloge de commande H₁, qui commande le premier module suiveur-bloqueur 20, est le même que le signal d'horloge de commande du premier bloc de commutation 14.

Ainsi, les modules suiveurs-bloqueurs 20, 22 sont commandés en opposition.

Avantageusement, les premier et deuxième modules suiveurs-bloqueurs 20, 22 fonctionnent en parallèle, ce qui permet de doubler la fréquence d'échantillonnage, tout en limitant le facteur de bruit par rapport à un branchement de modules suiveurs-bloqueurs en série, et en améliorant la linéarité.

Le dispositif échantillonneur-bloqueur 10 comprend également un module de sortie 26, qui réalise la recombinaison des échantillons en un signal de sortie, par entrelacement temporel.

Dans un mode de réalisation, le module de sortie 26 réalise également une amplification.

Le module de sortie 26 comprend un deuxième bloc de commutation 28 à deux commutateurs de sortie 30, 32, chacun des commutateurs de sortie ayant deux entrées et une sortie.

Une première sortie S_{20,1} du premier module suiveur-bloqueur 20 est branchée à une première entrée E_{30,1} du premier commutateur de sortie 30, et une deuxième sortie S20,2 du premier module suiveur-bloqueur 20 est branchée à une première entrée E_{32,1} du deuxième commutateur de sortie 32.

Une première sortie S_{22,1} du deuxième module suiveur-bloqueur 20 est branchée à une deuxième entrée E_{30,2} du premier commutateur de sortie 30, et une deuxième sortie S22,2 du deuxième module suiveur-bloqueur 22 est branchée à une deuxième entrée E_{32,2} du deuxième commutateur de sortie 32.

Les sorties S₁, S₂ du module de sortie 26 sont les sorties du dispositif échantillonneur-bloqueur 10.

Le deuxième bloc de commutation 28 est commandé par le signal d'horloge H₂ qui est inversé par rapport au premier signal d'horloge H₁ commandant le premier bloc de commutation 14.

Les deux commutateurs de sortie 30, 32 du deuxième bloc de commutation 28 sont ainsi commandés pour basculer périodiquement, en fonction du signal de commande qui est le signal d'horloge H₂, entre une première position de fonctionnement et une deuxième position de fonctionnement.

Dans la première position de fonctionnement, le premier commutateur de sortie 30 connecte la première sortie S_{22,1} du deuxième module suiveur-bloqueur 22, après amplification, à la première sortie S₁, et le deuxième commutateur de sortie 32 connecte la deuxième sortie S_{22,2} du deuxième module suiveur-bloqueur 22, après amplification, à la deuxième sortie S₂.

Dans la deuxième position de fonctionnement, le premier commutateur de sortie 30 connecte la première sortie S_{20,1} du premier module suiveur-bloqueur 20, après amplification, à la première sortie S₁, et le deuxième commutateur de sortie 32 connecte la deuxième sortie S_{20,2} du premier module suiveur-bloqueur 20, après amplification, à la deuxième sortie S₂.

En d'autres termes, le deuxième bloc de commutation 28, qui réalise une fonction de recombinaison synchronisée, cadencée par le signal d'horloge H₂, transmet le signal de la voie B vers la sortie lorsque cette voie est en mode bloqué et le signal de la voie A vers la sortie lorsque cette voie est en mode bloqué.

De plus, pour chacune des voies respectives, la voie A et la voie B, une boucle de retour 34, 36 est branchée entre les sorties et les entrées.

Chacune des boucles de retour 34, 36 est composée, selon la manière classique dite à double commutation d'un amplificateur opérationnel 38, 40 et d'un bloc de commutation 42, 44 à deux entrées, quatre sorties, dont deux sorties sont branchées à la masse M.

Ainsi, les sorties respectives S_{20,1} et S_{20,2} du premier module suiveur-bloqueur 20 sont connectées aux entrées de l'amplificateur 38, dont les sorties sont fournies en entrée du troisième bloc de commutation 42 comportant deux commutateurs 46, 48.

Dans une première position de fonctionnement du troisième bloc de commutation 42, une première sortie de l'amplificateur 38, correspondant à la première sortie S_{20,1} du premier module suiveur-bloqueur 20 est ramenée sur la première entrée E_{20,1} du premier module suiveur-bloqueur 20 , et une deuxième sortie de l'amplificateur 38, correspondant à la deuxième sortie S_{20,2} du premier module suiveur-bloqueur 20 est ramenée sur la deuxième entrée E_{20,2} du premier module suiveur-bloqueur 20.

Dans une deuxième position de fonctionnement du troisième bloc de commutation 42, la première sortie et la deuxième sortie de l'amplificateur 38 sont ramenées à la masse M.

Le troisième bloc de commutation 42 est commandé par le signal d'horloge H₁, synchronisé avec le signal de commande du premier module suiveur-bloqueur 20.

Les sorties respectives S_{22,1} et S_{22,2} du deuxième module suiveur-bloqueur 22 sont connectées aux entrées de l'amplificateur 40, dont les sorties sont fournies en entrée du quatrième bloc de commutation 44 comportant deux commutateurs 50, 52.

Dans une première position de fonctionnement du quatrième bloc de commutation 44, une première sortie de l'amplificateur 40, correspondant à la première sortie S_{22,1} du deuxième module suiveur-bloqueur 22 est ramenée sur la première entrée E_{22,1} du deuxième module suiveur-bloqueur 22 , et une deuxième sortie de l'amplificateur 40, correspondant à la deuxième sortie S_{22,2} du deuxième module suiveur-bloqueur 20 est ramenée sur la deuxième entrée E_{22,2} du deuxième module suiveur-bloqueur 22.

Dans une deuxième position de fonctionnement du quatrième bloc de commutation 44, la première sortie et la deuxième sortie de l'amplificateur 40 sont ramenées à la masse M.

Le quatrième bloc de commutation 44 est commandé par le signal d'horloge H₂, synchronisé avec le signal de commande du deuxième module suiveur-bloqueur 22.

Dans un mode de réalisation optimisé, afin d'améliorer la synchronisation entre la voie A et la voie B, et indépendamment de la fréquence d'échantillonnage, un courant de décalage, I_{offset}, est appliqué en entrée d'un amplificateur limiteur pour corriger la valeur du rapport cyclique des deux voies.

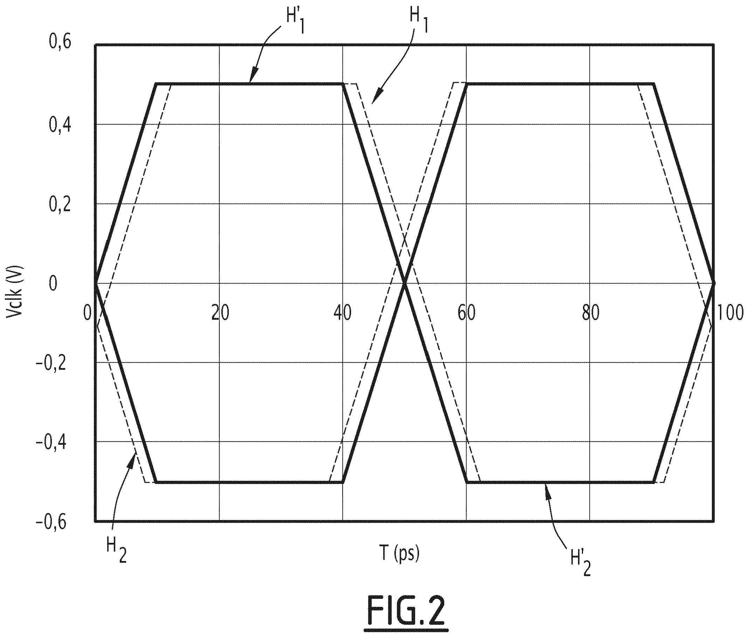

La figure 2 illustre un exemple de chronogramme de signaux d'horloge H₁ et H₂, avant et après application d'un courant de décalage I_{offset}.

Le graphe de la figure 2 illustre la tension (V_{clk}) des signaux d'horloge en Volts en fonction du temps en picosecondes.

En trait pointillé on représente les signaux d'horloge H₁, H₂ avant application du courant de décalage I_{offset}, et en trait plein les mêmes signaux d'horloge, notés H'1, H'₂, après application du courant de décalage I_{offset}.

La valeur de courant de décalage I_{offset} à appliquer, qui peut être positive ou négative, est déterminée par l'écart mesuré entre le rapport cyclique des signaux en sorties et un rapport cyclique de référence de 50%.

Grâce à l'application du courant de décalage I_{offset}, le rapport cyclique entre les signaux d'horloge H₁ et H₂ est ramené à 50%, comme on peut le constater à la figure 2.

Lorsque le rapport cyclique des signaux d'horloge des deux voies est supérieur à 50%, un courant de décalage positif permet de réduire ce rapport cyclique pour atteindre 50%. Lorsque le rapport cyclique des signaux d'horloge des deux voies est inférieur à 50%, un courant de décalage négatif permet d'augmenter celui-ci pour atteindre 50%.

L'application d'un courant de décalage I_{offset} permet de corriger d'un décalage de tension le signal de sortie du dispositif échantillonneur-bloqueur.

Avantageusement, l'utilisation d'un courant de décalage permet d'améliorer la synchronisation et la linéarité du dispositif échantillonneur-bloqueur, sans nécessiter de traitement numérique ultérieur.

Le dispositif échantillonneur-bloqueur 10 décrit permet de réaliser un échantillonnage avec une fréquence d'échantillonnage 2xFₛ, égale au double de la fréquence Fₛ du signal d'horloge généré par le générateur d'horloge 24.

En variante, il est possible de combiner N modules suiveurs-bloqueurs branchés en parallèle selon le principe de l'invention décrit ci-dessus pour réaliser un échantillonnage avec une fréquence de NxFₛ.

## Revendications

1. Dispositif échantillonneur-bloqueur de signal électrique comportant un module d'entrée (12) ayant deux entrées (E₁, E₂), comportant un premier bloc de commutation (14) comportant deux commutateurs d'entrée (16,18), chaque entrée (E₁, E₂) du module d'entrée (12) étant branchée en entrée d'un desdits commutateurs d'entrée (16, 18), le module d'entrée (12) étant branché en entrée d'un premier module suiveur-bloqueur (20) à deux entrées (E_{20,1} ; E_{20,2}) et deux sorties (S_{20,1} ; S_{20,2}), de manière à acheminer alternativement le signal d'une des deux entrées (E₁, E₂) vers une des deux entrées (E_{20,1} ; E_{20,2}) du premier module suiveur-bloqueur (20),
**caractérisé en ce qu'**il comporte :
- un deuxième module suiveur-bloqueur (22) branché en parallèle du premier module suiveur-bloqueur (20), lesdits premier module suiveur-bloqueur (20) et deuxième module suiveur-bloqueur (22) étant branchés en sortie du premier bloc de commutation (14), et
- un module de sortie (26) comportant un deuxième bloc de commutation (28) comportant deux commutateurs de sortie (30,32), les sorties desdits premier module suiveur-bloqueur (20) et deuxième module suiveur-bloqueur (22) étant branchées aux entrées des commutateurs de sortie (30, 32) de manière à réaliser un entrelacement temporel des signaux de sortie du premier module suiveur-bloqueur (20) et du deuxième module suiveur-bloqueur (22),
- le dispositif comportant en outre une première boucle de retour (34) branchée entre les sorties et les entrées du premier module suiveur-bloqueur (20), et une deuxième boucle de retour (36) branchée entre les sorties et les entrées du deuxième module suiveur-bloqueur (22).

2. Dispositif échantillonneur-bloqueur selon la revendication 1, dans lequel le premier bloc de commutation (14) comprend un premier commutateur d'entrée (16) et un deuxième commutateur d'entrée (18), une première sortie (S_{16,1}) du premier commutateur d'entrée (16) étant branchée à une première entrée (E_{20,1}) du premier module suiveur-bloqueur (20), et une deuxième sortie (S_{16,2}) du premier commutateur d'entrée (16) étant branchée à une première entrée (E_{22,1}) du deuxième module suiveur-bloqueur (22),
une première sortie (S_{18,1}) du deuxième commutateur d'entrée (18) étant branchée à une deuxième entrée (E_{20,2}) du premier module suiveur-bloqueur (20), et une deuxième sortie (S_{18,2}) du deuxième commutateur d'entrée (18) étant branchée à une deuxième entrée (E_{22,2}) du deuxième module suiveur-bloqueur (22).

3. Dispositif échantillonneur-bloqueur selon la revendication 2, dans lequel dans une première position de fonctionnement, le premier commutateur d'entrée (16) connecte la première entrée (E₁) à la première entrée (E_{20,1}) du premier module suiveur-bloqueur (20), et le deuxième commutateur d'entrée (18) connecte la deuxième entrée (E₂) à la deuxième entrée (E_{20,2}) du premier module suiveur-bloqueur (20).

4. Dispositif échantillonneur-bloqueur selon la revendication 2 ou 3, dans lequel dans une deuxième position de fonctionnement, le premier commutateur d'entrée (16) connecte la première entrée (E₁) à la première entrée (E_{22,1}) du deuxième module suiveur-bloqueur (22), et le deuxième commutateur d'entrée (18) connecte la deuxième entrée (E₂) à la deuxième entrée (E_{22,2}) du deuxième module suiveur-bloqueur (22).

5. Dispositif échantillonneur-bloqueur selon l'une quelconque des revendications 1 à 4, comprenant en outre un générateur d'horloge (24), apte à générer un premier signal d'horloge (H₁) de fréquence prédéterminée, et un deuxième signal d'horloge (H₂), de même fréquence prédéterminée et inversé par rapport au premier signal d'horloge (H₁).

6. Dispositif échantillonneur-bloqueur selon la revendication 5, dans lequel le premier module suiveur-bloqueur (20) est commandé par le premier signal d'horloge, et le deuxième module suiveur-bloqueur (22) est commandé par le deuxième signal d'horloge.

7. Dispositif échantillonneur-bloqueur selon l'une des revendications 5 ou 6, dans lequel le premier bloc de commutation (14) est commandé par ledit premier signal d'horloge (H₁) apte à commander le basculement des deux commutateurs d'entrée (16, 18) du premier bloc de commutation (14) entre une première position de fonctionnement et une deuxième position de fonctionnement.

8. Dispositif échantillonneur-bloqueur selon l'une des revendications 5 à 7, dans lequel le deuxième bloc de commutation (28) est commandé par ledit deuxième signal d'horloge (H₂) apte à commander le basculement des deux commutateurs de sortie (30, 32) entre une première position de fonctionnement et une deuxième position de fonctionnement.

9. Dispositif échantillonneur-bloqueur selon l'une des revendications 5 à 8, dans lequel lesdits premier signal d'horloge (H₁) et deuxième signal d'horloge (H₂) présentent un rapport cyclique différent de 50%, et dans lequel un courant de décalage (I_{offset}) est appliqué au générateur d'horloge (24), de manière à corriger le rapport cyclique.

## Patentansprüche

1. Abtast- und Haltevorrichtung für elektrische Signale, umfassend ein Eingangsmodul (12), das zwei Eingänge (E₁, E₂) aufweist, umfassend einen ersten Schaltblock (14), umfassend zwei Eingangsschalter (16, 18), wobei jeder Eingang (E₁, E₂) des Eingangsmoduls (12) mit dem Eingang eines der Eingangsschalter (16, 18) verbunden ist, wobei das Eingangsmodul (12) an dem Eingang eines ersten Folger-Haltemoduls (20) mit zwei Eingängen (E_{20,1}; E_{20,2}) und zwei Ausgängen (S_{20,1}; S_{20,2}) verbunden ist, sodass das Signal von einem der zwei Eingänge (E₁, E₂) abwechselnd zu einem der zwei Eingänge (E_{20,1}; E_{20,2}) des ersten Folger-Haltemoduls (20) geleitet wird,
**dadurch gekennzeichnet ist, dass** sie Folgendes umfasst:
- ein zweites Folger-Haltemodul-Modul (22), das parallel zu dem ersten Folger-Haltemodul-Modul (20) verbunden ist, wobei das erste Folger-Haltemodul-Modul (20) und das zweite Folger-Haltemodul-Modul (22) an dem Ausgang des ersten Schaltblocks (14) verbunden sind, und
- ein Ausgangsmodul (26), umfassend einen zweiten Schaltblock (28), umfassend zwei Ausgangsschalter (30, 32), wobei die Ausgänge des ersten Folger-Haltemoduls (20) und des zweiten Folger-Haltemoduls (22) mit den Eingängen der Ausgangsschalter (30, 32) verbunden sind, um eine zeitliche Verschachtelung der Ausgangssignale des ersten Folger-Haltemoduls (20) und des zweiten Folger-Haltemoduls (22) zu bewirken,
- die Vorrichtung ferner umfassen eine erste Rückkopplungsschleife (34), die zwischen den Ausgängen und Eingängen des ersten Folge- und Haltemoduls (20) verbunden ist, und eine zweite Rückkopplungsschleife (36), die zwischen den Ausgängen und Eingängen des zweiten Folge- und Haltemoduls (22) verbunden ist.

2. Abtast- und Haltevorrichtung nach Anspruch 1, wobei der erste Schaltblock (14) einen ersten Eingangsschalter (16) und einen zweiten Eingangsschalter (18) umfasst, ein erster Ausgang (S_{16,1}) des ersten Eingangsschalters (16) mit einem ersten Eingang (E_{20,1}) des ersten Folger-Haltemodul-Moduls (20) verbunden ist, und ein zweiter Ausgang (S_{16,2}) des ersten Eingangsschalters (16) mit einem ersten Eingang (E_{22,1}) des zweiten Folger-Haltemodul-Moduls (22) verbunden ist,
ein erster Ausgang (S_{18,1}) des zweiten Eingangsschalters (18) mit einem zweiten Eingang (E_{20,2}) des ersten Folger-Haltemoduls (20) verbunden ist, und ein zweiter Ausgang (S_{18,2}) des zweiten Eingangsschalters (18) mit einem zweiten Eingang (E_{22,2}) des zweiten Folger-Haltemoduls (22) verbunden ist.

3. Abtast- und Haltevorrichtung nach Anspruch 2, wobei in einer ersten Betriebsposition der erste Eingangsschalter (16) den ersten Eingang (E₁) mit dem ersten Eingang (E_{20,1}) des ersten Folger- und Haltemoduls (20) verbindet und der zweite Eingangsschalter (18) den zweiten Eingang (E₂) mit dem zweiten Eingang (E_{20,2}) des ersten Folger- und Haltemoduls (20) verbindet.

4. Abtast- und Haltevorrichtung nach Anspruch 2 oder 3, wobei in einer zweiten Betriebsposition der erste Eingangsschalter (16) den ersten Eingang (E₁) mit dem ersten Eingang (E_{22,1}) des zweiten Folge- und Haltemoduls (22) verbindet, und der zweite Eingangsschalter (18) den zweiten Eingang (E₂) mit dem zweiten Eingang (E_{22,2}) des zweiten Folge- und Haltemoduls (22) verbindet.

5. Abtast- und Haltevorrichtung nach einem der Ansprüche 1 bis 4, ferner umfassend einen Taktgenerator (24), der geeignet ist, um ein erstes Taktsignal (H₁) mit einer vorbestimmten Frequenz und ein zweites Taktsignal (H₂) mit derselben vorbestimmten Frequenz, das in Bezug auf das erste Taktsignal (H₁) invertiert ist, zu erzeugen.

6. Abtast- und Haltevorrichtung nach Anspruch 5, wobei das erste Folger- und Haltemodul (20) durch das erste Taktsignal gesteuert wird und das zweite Folger- und Haltemodul (22) durch das zweite Taktsignal gesteuert wird.

7. Abtast- und Haltevorrichtung nach einem der Ansprüche 5 oder 6, wobei der erste Schaltblock (14) durch das erste Taktsignal (H₁) gesteuert wird, das geeignet ist, um das Umschalten der zwei Eingangsschalter (16, 18) des ersten Schaltblocks (14) zwischen einer ersten Betriebsposition und einer zweiten Betriebsposition zu steuern.

8. Abtast- und Haltevorrichtung nach einem der Ansprüche 5 bis 7, wobei der zweite Schaltblock (28) durch das zweite Taktsignal (H₂) gesteuert wird, das geeignet ist, um das Umschalten der zwei Ausgangsschalter (30, 32) zwischen einer ersten Betriebsposition und einer zweiten Betriebsposition zu steuern.

9. Abtast- und Haltevorrichtung nach einem der Ansprüche 5 bis 8, wobei das erste Taktsignal (H₁) und das zweite Taktsignal (H₂) ein von 50 % verschiedenes Tastverhältnis aufweisen, und, wobei ein Verschiebungsstrom (I_{offset}) an den Taktgenerator (24) angelegt wird, um das Tastverhältnis zu korrigieren.

## Claims

1. A sample-and-hold device for an electrical signal including an input module (12) having two inputs (E₁, E₂), including a first switching block (14) including two input switches (16, 18), each input (E₁, E₂) of the input module (12) being connected at the input of one of said input switches (16, 18), the input module (12) being connected at the input of a first follow-and-hold module (20) with two inputs (E_{20.1}; E_{20.2}) and two outputs (S_{20.1}; S_{20.2}), so as to alternately convey the signal from one of the two inputs (E₁, E₂) to one of the two inputs (E_{20.1}; E_{20.2}) of the first follow-and-hold module (20),
**characterized in that** it includes:
- a second follow-and-hold module (22) connected in parallel with the first follow-and-hold module (20), said first follow-and-hold module (20) and second follow-and-hold module (22) being connected at the output of the first switching block (14), and
- an output module (26) including a second switching block (28) including two output switches (30, 32), the outputs of said first follow-and-hold module (20) and second follow-and-hold module (22) being connected to the inputs of the output switches (30, 32) so as to perform time interleaving of the output signals of the first follow-and-hold module (20) and the second follow-and-hold module (22),
the device further including a first feedback loop (34) connected between the outputs and the inputs of the first track-and-hold module (20), and a second feedback loop (36) connected between the outputs and the inputs of the second track-and-hold module (22).

2. The sample-and-hold device according to claim 1, wherein the first switching block (14) comprises a first input switch (16) and a second input switch (18), a first output (S_{16.1}) of the first input switch (16) being connected to a first input (E_{20.1}) of the first track-and-hold module (20), and a second output (S_{16.2}) of the first input switch (16) being connected to a first input (E_{22.1}) of the second track-and-hold module (22),
a first output (S_{18.1}) of the second input switch (18) being connected to a second input (E_{20.2}) of the first track-and-hold module (20), and a second output (S_{18.2}) of the second input switch (18) being connected to a second input (E_{22.2}) of the second track-and-hold module (22).

3. The sample-and-hold device according to claim 2, wherein in a first operating position, the first input switch (16) connects the first input (E₁) to the first input (E_{20.1}) of the first track-and-hold module (20), and the second input switch (18) connects the second input (E₂) to the second input (E_{20.2}) of the first track-and-hold module (20).

4. The sample-and-hold device according to claim 2 or 3, wherein in a second operating position, the first input switch (16) connects the first input (E₁) to the first input (E_{22.1}) of the second track-and-hold module (22), and the second input switch (18) connects the second input (E₂) to the second input (E_{22.2}) of the second track-and-hold module (22).

5. The sample-and-hold device according to any one of claims 1 to 4, further comprising a clock generator (24), able to generate a first clock signal (H₁) with a predetermined frequency, and a second clock signal (H₂), with a same predetermined frequency, reversed relative to the first clock signal (H₁).

6. The sample-and-hold device according to claim 5, wherein the first track-and-hold module (20) is commanded by the first clock signal, and the second track-and-hold module (22) is commanded by the second clock signal.

7. The sample-and-hold device according to one of claims 5 or 6, wherein the first switching block (14) is commanded by said first clock signal (H₁) able to command the switching of the two input switches (16, 18) of the first switching block (14) between a first operating position and a second operating position.

8. The sample-and-hold device according to one of claims 5 to 7, wherein the second switching block (28) is commanded by said second clock signal (H₂) able to command the switching of the two output switches (30, 32) between a first operating position and a second operating position.

9. The sample-and-hold device according to one of claims 5 to 8, wherein said first clock signal (H₁) and second clock signal (H₂) have a duty factor differing by 50%, and in which an offset current (I_{offset}) is applied to the clock generator (24), so as to correct the duty factor.
